# EUROPEAN PATENT APPLICATION

(11) **EP 4 220 289 A1**
(43) Date of publication of application: **02.08.2023**
(21) Application number: 23151054.6
(22) Date of filing: 11.01.2023
(51) Int. Cl.: G02F 1/1362, H01L 27/12

(54) **MODULATION DEVICE**

(30) Priority: 27.01.2022 US 202263303502 P; 28.09.2022 CN 202211190763
(71) Applicant: InnoLux Corporation, Jhunan Town Miao li 35053 (TW)
(72) Inventor: TSAI, Tsung-Han, 35053 Jhunan Town, Miaoli County (TW); LIUS, Chandra, 35053 Jhunan Town, Miaoli County (TW)
(74) Representative: Becker, Eberhard

(57) **Abstract**

A modulation device including a substrate, a modulation unit, a data line, and a scan line is provided. The modulation unit is disposed on the substrate. The data line is disposed on the substrate and is electrically connected to the modulation unit. The scan line is disposed on the substrate, and has an overlapping area overlapping the data line and a non-overlapping area not overlapping the data line. In a first direction, the scan line has a first width in the overlapping area, and the scan line has a second width in the non-overlapping area. The first width is smaller than the second width. The modulation device of the disclosure reduces a resistance-capacitance loading.

## Description

### BACKGROUND

### Technical Field

The disclosure relates to a modulation device.

### Description of Related Art

A circuit layout in a large-scale modulation device is relatively complex. Therefore, a coupling effect between circuits used for transmitting different signals may increase a resistance-capacitance loading (RC loading), which affects signal transmission quality, and results in a decrease in reliability of the modulation device.

### SUMMARY

The disclosure is directed to a modulation device, which is adapted to reduce an impedance and/or capacitance loading of circuits used for transmitting different signals, so as to reduce a resistance-capacitance loading.

According to an embodiment of the disclosure, a modulation device includes a substrate, a modulation unit, a data line, and a scan line. The modulation unit is disposed on the substrate. The data line is disposed on the substrate and is electrically connected to the modulation unit. The scan line is disposed on the substrate, and has an overlapping area overlapping the data line and a non-overlapping area not overlapping the data line. In a first direction, the scan line has a first width in the overlapping area, and the scan line has a second width in the non-overlapping area. The first width is smaller than the second width.

According to an embodiment of the disclosure, a modulation device includes a substrate, a modulation unit, a data line, and a scan line. The modulation unit is disposed on the substrate. The data line is disposed on the substrate and is electrically connected to the modulation unit. The scan line is disposed on the substrate and partially overlaps the data line. The data line has an overlapping area overlapping the scan line and a non-overlapping area not overlapping the scan line. In a second direction, the data line has a third width in the overlapping area, and the data line has a fourth width in the non-overlapping area. The third width is smaller than the fourth width.

According to an embodiment of the disclosure provides a modulation device includes a substrate, multiple modulation units, a data line, and a scan line. The modulation units are disposed on the substrate. The data line is disposed on the substrate and is electrically connected to at least one of the modulation units. The scan line is disposed on the substrate and is disposed in parallel with the data line.

In order for the aforementioned features and advantages of the disclosure to be more comprehensible, several embodiments accompanied with drawings are described in detail as follows.

### BRIEF DESCRIPTION OF THE DRAWINGS

The accompanying drawings are included to provide a further understanding of the disclosure, and are incorporated in and constitute a part of this specification. The drawings illustrate embodiments of the disclosure and, together with the description, serve to explain the principles of the disclosure.
FIG. 1A is a partial schematic top view of a modulation device according to a first embodiment of the disclosure.
FIG. 1B is a schematic cross-sectional view of an embodiment viewing along a section line A1-A1' of FIG. 1A.
FIG. 1C is a partial schematic top view of an arrangement relationship of a scan line and a data line in a modulation device according to an embodiment of the disclosure.
FIG. 1D is a partial schematic top view of an arrangement relationship of a scan line and a data line in a modulation device according to another embodiment of the disclosure.
FIG. 1E is a schematic cross-sectional view of an embodiment viewing along a section line A2-A2' of FIG. 1A.
FIG. 1F is a schematic cross-sectional view of another embodiment viewing along the section line A2-A2' of FIG. 1A.
FIG. 1G is a schematic cross-sectional view of still another embodiment viewing along the section line A2-A2' of FIG. 1A.
FIG. 2A is a partial schematic top view of a modulation device according to a second embodiment of the disclosure.
FIG. 2B is a schematic cross-sectional view of an embodiment viewing along a section line B-B' of FIG. 2A.
FIG. 2C is a schematic cross-sectional view of another embodiment viewing along the section line B-B' of FIG. 2A.
FIG. 3A is a partial schematic top view of a modulation device according to a third embodiment of the disclosure.
FIG. 3B is a schematic cross-sectional view of an embodiment viewing along a section line C-C' of FIG. 3A.
FIG. 4 is a partial schematic top view of a modulation device according to a fourth embodiment of the disclosure.
FIG. 5A is a partial schematic top view of a modulation device according to a fifth embodiment of the disclosure.
FIG. 5B is a schematic cross-sectional view of an embodiment viewing along a section line D1-D1' of FIG. 5A.
FIG. 5C is a schematic cross-sectional view of an embodiment viewing along a section line D2-D2' of FIG. 5A.
FIG. 5D is a schematic cross-sectional view of another embodiment viewing along the section line D2-D2' of FIG. 5A.
FIG. 6A is a partial schematic top view of a modulation device according to a sixth embodiment of the disclosure.
FIG. 6B is a schematic cross-sectional view of an embodiment viewing along a section line E-E' of FIG. 6A.
FIG. 7 is a partial schematic top view of an arrangement relationship between a scan line and a common line in a modulation device according to an embodiment of the disclosure.
FIG. 8A is a partial schematic top view of a modulation device according to a seventh embodiment of the disclosure.
FIG. 8B is a partial schematic top view of a driving circuit of the modulation device of FIG. 8A.
FIG. 9A is a partial schematic top view of a photosensitive device according to an embodiment of the disclosure.
FIG. 9B is a schematic cross-sectional view of an embodiment viewing along a section line F-F' of FIG. 9A.
FIG. 10 is a partial schematic top view of a modulation device according to an eighth embodiment of the disclosure.

### DESCRIPTION OF THE EMBODIMENTS

The disclosure may be understood by referring to the following detailed description in collaboration with the accompanying drawings. It should be noted that, in order to make the reader easy to understand and the drawings concise, the drawings in the disclosure only depict a part of an electronic device, and specific components in the drawings are not drawn according to actual scales. In addition, the number and size of each component in the figures are for illustration only, and are not intended to limit a scope of the disclosure.

Throughout the disclosure and the appended claims, certain terms may be used to refer to specific components. Those skilled in the art should understand that electronic device manufacturers may refer to a same component by different names. This specification does not intend to distinguish between components that have the same function but different names. In the following description and claims, terms such as "including", "containing" and "having" are open-ended words, so that they should be interpreted as meaning "including but not limited to...". Therefore, when the terms "including", "containing" and/or "having" are used in the description of the disclosure, they designate the presence of corresponding features, regions, steps, operations and/or components, but do not preclude the presence of one or more other features, regions, steps, operations, operations, and/or components.

Directional terms mentioned in the specification, such as "up", "down", "front", "rear", "left", "right", etc., only refer to directions of the drawings. Therefore, the used directional terms are illustrative, not limiting, of the disclosure. In the drawings, various figures illustrate general characteristics of methods, structures and/or materials used in particular embodiments. However, these drawings should not be construed to define or limit the scope or nature encompassed by these embodiments. For example, the relative sizes, thicknesses and positions of various layers, regions and/or structures may be reduced or exaggerated for clarity's sake.

When a corresponding component (for example, a film layer or region) is referred to as being "on" another component, it may be directly on the other component or there may be other components there between. On the other hand, when a component is referred to as being "directly on another component," there is no component there between. In addition, when a component is referred to as being "on another component ", the two components have a top-down relationship in a top view, and the component may be above or below the other component, and the top-down relationship depends on an orientation of the device.

The terms "about", "substantially" or "approximately" are generally interpreted as within 10% of a given value or range, or as within 5%, 3%, 2%, 1% or 0.5% of the given value or range.

The ordinal numbers used in the specification and claims, such as "first", "second", etc., are used to modify components, and do not imply and represent that the component or these components have any previous ordinal numbers, and do not represent a sequence of one component with another, or a sequence in a manufacturing method. The use of these ordinal numbers is only to make a clear distinction between one component with a certain name and another component with the same name. The same terms may not be used in the claims and the specification, and accordingly, a first component in the specification may be a second component in the claims.

It should be noted that in the following embodiments, features in different embodiments may be substituted, reorganized, and mixed to complete other embodiments without departing from the spirit of the present disclosure. The features of the various embodiments may be mixed and matched arbitrarily as long as they do not violate or conflict with the spirit of the disclosure.

The electrical connection or coupling described in this disclosure may refer to direct connection or indirect connection. In the case of direct connection, terminals of components on two circuits are directly connected or connected to each other by a conductor line segment, and in the case of indirect connection, there are switches, diodes, capacitors, inductors, resistors, other suitable components, or a combination of the above components between the terminals of the components on the two circuits, but the disclosure is not limited thereto.

In the disclosure, a thickness, length, width, and area may be measured by using an optical microscope, and the thickness may be obtained by measuring a cross-sectional image in the electron microscope, but the disclosure is not limited thereto. In addition, there may be a certain error in any two values or directions used for comparison. If a first value is equal to a second value, it implies that there may be an error of about 10% between the first value and the second value; if a first direction is perpendicular to a second direction, an angle between the first direction and the second direction may be between 80 degrees and 100 degrees; if the first direction is parallel to the second direction, the angle between the first direction and the second direction may be between 0 degrees and 10 degrees.

The electronic device of the disclosure may include a display device, an antenna device, a reconfigurable intelligent surface device, a signal feeding device, a waveguide device, a sensing device, a light-emitting device, or a splicing device, but the disclosure is not limited thereto. The electronic device may include a bendable or flexible electronic device. The electronic device may include electronic components. The electronic device includes, for example, a liquid crystal layer or a light emitting diode (LED). The electronic components may include passive components and active components, such as capacitors, resistors, inductors, variable capacitors, filters, diodes, transistors, inductors, MEMS, liquid crystal chips, etc., but the disclosure is not limited thereto. The diodes may include light emitting diodes or photodiodes. The light emitting diodes may include, for example, organic light emitting diodes (OLEDs), mini LEDs, micro LEDs, quantum dot LEDs, fluorescence, phosphor or other suitable materials, or a combination of the above materials, but the disclosure is not limited thereto. The sensors may include, for example, capacitive sensors, optical sensors, electromagnetic sensors, fingerprint sensors (FPS), touch sensors, antennas, or pen sensors, etc., but the disclosure is not limited thereto. Hereinafter, a display device is taken as the electronic device to describe the content of the disclosure, but the disclosure is not limited thereto.

Exemplary embodiments of the disclosure are provided below, where the same element symbols are used to represent the same or similar parts in the figures and descriptions.

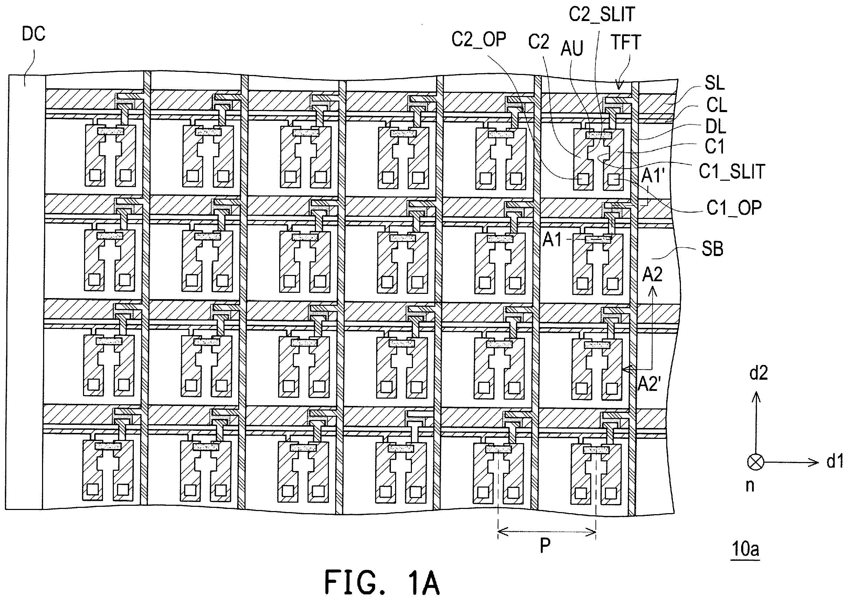

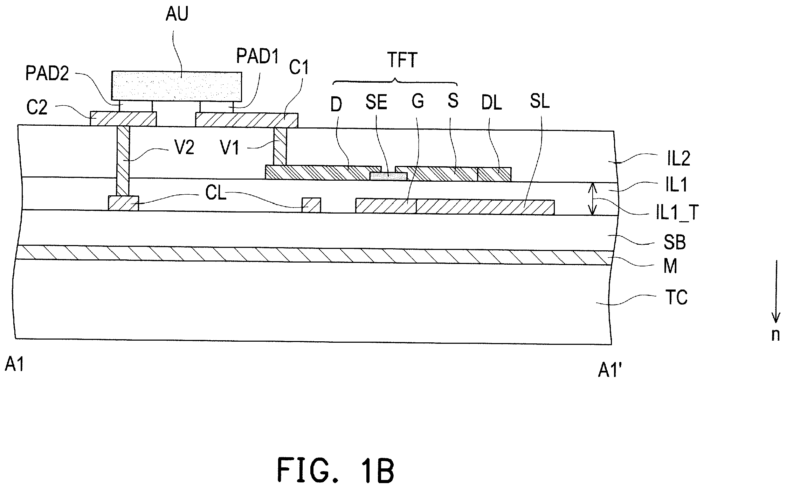

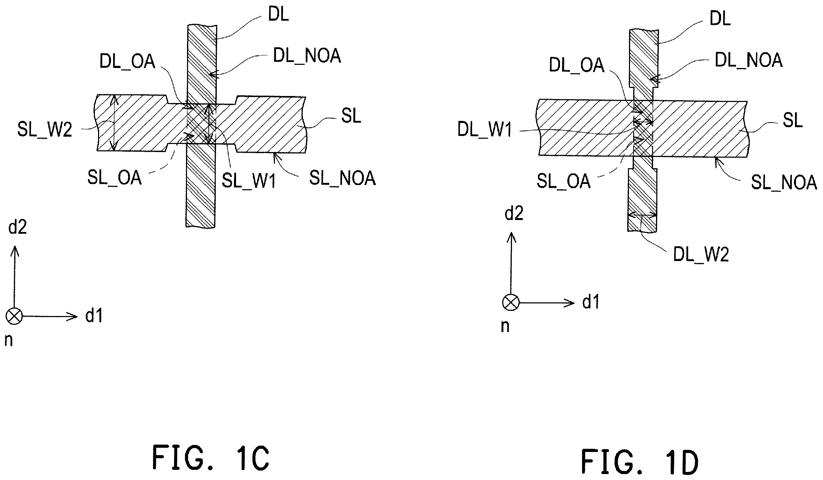

FIG. 1A is a partial schematic top view of a modulation device according to a first embodiment of the disclosure. FIG. 1B is a schematic cross-sectional view of an embodiment viewing along a section line A1-A1' of FIG. 1A. FIG. 1C is a partial schematic top view of an arrangement relationship of a scan line and a data line in a modulation device according to an embodiment of the disclosure. FIG. 1D is a partial schematic top view of an arrangement relationship of a scan line and a data line in a modulation device according to another embodiment of the disclosure.

Referring to FIG. 1A and FIG. 1B at the same time, a modulation device 10a of the embodiment includes a substrate SB, modulation units AU, scan lines SL and data lines DL. The modulation device 10a may be applied to, for example, a communication field, a radar/lidar field, a reconfigurable intelligent surface (RIS) technology or other suitable fields/technologies, but the disclosure is not limited thereto.

A material of the substrate SB may be, for example, glass, plastic or a combination thereof. For example, the material of the substrate SB may include quartz, sapphire, silicon (Si), germanium (Ge), silicon carbide (SiC), gallium nitride (GaN), silicon germanium (SiGe), polymethyl methacrylate (PMMA), polycarbonate (PC), polyimide (PI), polyethylene terephthalate (PET) or other suitable materials or a combination of the above materials, which is not limited by the disclosure.

The modulation units AU are, for example, disposed on the substrate SB. In some embodiments, the modulation unit AU may include a varactor diode, a variable capacitor, a variable resistor, a phase shifter, an amplifier, an antenna, a biometric sensor, a graphene sensor, other suitable elements, or a combination thereof. For example, the modulation unit AU of the embodiment includes a varactor diode, and the varactor diode may provide different capacitance values according to signals provided by a driving circuit DC and a transistor TFT to be described later, i.e., by changing a voltage across the varactor diode, a magnitude of the capacitance value of the varactor diode may be changed. Therefore, by adjusting the capacitance value of the varactor diode, the modulation device 10a of the embodiment may implement adjustment of an operating frequency band, but the disclosure is not limited thereto. In some embodiments, a pitch P between adjacent modulation units AU in a same row is related to a wavelength of an electromagnetic wave to be adjusted. For example, the pitch P between the adjacent modulation units AU is, for example, about a half of the wavelength of the electromagnetic wave to be adjusted, but the disclosure is not limited thereto.

The scan lines SL and the data lines DL are, for example, disposed on the substrate SB. The scan line SL is, for example, electrically connected to the transistor TFT to be described later, and the data line DL is, for example, electrically connected to the modulation unit AU. In some embodiments, the scan lines SL extend toward a first direction d1, and the data lines DL extend toward a second direction d2, where the first direction d1 is different from the second direction d2. In the embodiment, the first direction d1 is perpendicular to the second direction d2, but the disclosure is not limited thereto. For example, the scan line SL partially overlaps the data line DL, where the data line DL partially covers the scan line SL, but the disclosure is not limited thereto. In the embodiment, the scan line SL and the data line DL have an overlapping area and a non-overlapping area. In detail, the aforementioned overlapping area is defined as an area where the scan line SL and the data line DL are overlapped in a top view direction n of the substrate SB, where the top view direction n is, for example, perpendicular to the first direction d1 and the second direction d2. The line SL has an overlapping area SL_OA that overlaps with the data line DL and a non-overlapping area SL_NOA that does not overlap the data line DL; or the data line DL has an overlapping area DL_OA that overlaps the scan line SL and a non-overlapping area DL_NOA that does not overlap the scan line SL.

In the embodiment, the scan line SL and/or the data line DL may have a following design to reduce a capacitance loading of the modulation device 10a, where the capacitance loading generated by the scan line SL and the data line DL may be, for example, conformed to a following relationship: C= (ε·A)/d, where C is the capacitance loading generated by the scan line SL and the data line DL, ε is a permittivity of a medium between the scan line SL and the data line DL, A is the overlapping area of scan line SL and the data line DL in the top view direction n of substrate SB, and d is a distance between the scan line SL and the data line DL in the top view direction n of the substrate SB.

In some embodiments, as shown in FIG. 1C, the overlapping area SL_OA and the non-overlapping area SL_NOA of the scan line SL may have different widths in the second direction d2. In detail, the scan line SL has a first width SL_W1 in the overlapping area SL_OA along the second direction d2, the scan line SL has a second width SL_W2 in the non-overlapping area SL NOA along the second direction d2, and the first width SL_W1 is smaller than the second width SL_W2 (SL_W1<SL_W2). In other embodiments, as shown in FIG. 1D, the overlapping area DL_OA and the non-overlapping area DL_NOA of the data line DL may have different widths in the first direction d1. In detail, the data line DL in the overlapping area DL_OA has a third width DL_W1 in the first direction d1, the data line DL in the non-overlapping area DL_NOA has a fourth width DL_W2 in the first direction d1, and the third width DL_W1 is smaller than the fourth width DL_W2 (DL_W1<DL_W2).

Through the aforementioned design, the overlapping area of the scan line SL and the data line DL in the top view direction n of the substrate SB may be reduced, so that the capacitance loading generated by the scan line SL and the data line DL may be reduced, thereby improving signal transmission quality of the modulation device 10a.

In some embodiments, the modulation device 10a further includes an insulating layer IL1, an insulating layer IL2, a first electrode C1, a second electrode C2, a transistor TFT, a common line CL, a driving circuit DC, a heat dissipation structure TC, and a conductor layer M.

The insulating layer IL1 is, for example, provided on the substrate SB. In the embodiment, the insulating layer IL1 is disposed between the data line DL and the scan line SL, and covers the scan line SL. A material of the insulating layer IL1 may be, for example, an inorganic material (for example, silicon oxide, silicon nitride, silicon oxynitride, or a stack layer of the above at least two materials), an organic material (for example, polytetrafluoroethylene, polyimide, poly p-xylene, benzocyclobutene, or other suitable materials) or a combination of the above materials, but the disclosure is not limited thereto. The insulating layer IL1 (medium) disposed between the data line DL and the scan line SL may have a relatively low permittivity due to including the aforementioned materials, so that the capacitance loading generated by the scan line SL and the data line DL may be reduced, thereby improving the signal transmission quality of the modulation device 10a. In some embodiments, the permittivity of the insulating layer IL1 may be less than 5. In some other embodiments, the permittivity of the insulating layer IL1 may be less than 4. In still some other embodiments, the permittivity of the insulating layer IL1 may be less than 3.

In some embodiments, the insulating layer IL1 may be a single-layer structure or a multi-layer structure, which is not limited by the disclosure. In addition, in some embodiments, a thickness IL1_T of the insulating layer IL1 is 0.2 µm to 10 µm. In some other embodiments, the thickness IL1_T of the insulating layer IL1 is 1 µm to 5 µm. Since the thickness IL1_T of the insulating layer IL1 is substantially a distance between the scan line SL and the data line DL in the top view direction n of the substrate SB, when the thickness IL1_T of the insulating layer IL1 is within the aforementioned range, the distance of the data line DL in the top view direction n of the substrate SB may be relatively increased, so that the capacitance loading generated by the scan line SL and the data line DL may be reduced, thereby improving the signal transmission quality of the modulation device 10a.

The insulating layer IL2 is, for example, disposed on the substrate SB. In the embodiment, the insulating layer IL2 covers the data line DL. A material of the insulating layer IL2 may be the same as or similar to that of the insulating layer IL1, and detail thereof is not repeated.

The first electrode C1 and the second electrode C2 are, for example, disposed on the substrate SB. In the embodiment, the first electrode C1 and the second electrode C2 are disposed on the insulating layer IL2, and the first electrode C1 and the second electrode C2 may belong to a same metal layer, or may belong to different metal layers. In some embodiments, the first electrode C1 or/and the second electrode C2 may be composed of a single metal layer or multiple sub-metal layers, but the disclosure is not limited thereto. The modulation unit AU is, for example, disposed on the first electrode C1 and the second electrode C2, and may be electrically connected to the first electrode C1 and the second electrode C2 through, for example, pads PAD1 and PAD2, but the disclosure is not limited thereto. The first electrode C1 may, for example, have an opening C1_OP and/or a slit C1_SLIT, and the second electrode C2 may, for example, also have an opening C2_OP and/or a slot C2_SLIT. By making the first electrode C1 and the second electrode C2 to have the aforementioned design, a signal reflected by the first electrode C1 and/or the second electrode C2 may be reduced to obtain a controllable operating frequency range of the modulation unit AU. It should be noted that the embodiment does not limit the number of openings and/or slits of the first electrode C1 and the second electrode C2 to be one, nor does it limit that the first electrode C1 and the second electrode C2 must have openings and/or slits at the same time. The first electrode C1 and the second electrode C2 may be formed by, for example, a conventional patterning process. For example, the first electrode C1 and the second electrode C2 may be formed by laser direct structuring (LDS), but the disclosure is not limited thereto.

The transistor TFT may be, for example, electrically connected to the modulation unit AU to drive the modulation unit AU. The transistor TFT may, for example, include a gate G, a source S, a drain D and a semiconductor layer SE, but the disclosure is not limited thereto. In the embodiment, the gate G and the scan line SL belong to a same metal layer, and the source S, the drain D and the data line DL belong to a same metal layer, where the gate G is covered by the insulating layer IL1, the source S is covered by the insulating layer IL2, and the drain D is partially covered by the insulating layer IL2, but the disclosure is not limited thereto. The transistor TFT may be, for example, electrically connected to the modulation unit AU through a via V1 penetrating through the insulating layer IL2. In detail, the via V1 penetrates through the insulating layer IL2 in the top view direction n of the substrate SB, and exposes a part of the drain D of the transistor TFT, where the first electrode C1 is electrically connected to the drain D of the transistor TFT through the via V1, so that the modulation unit AU disposed on the first electrode C1 may be electrically connected to the transistor TFT.

In some embodiments, the scan line SL may be electrically connected to the gate G of the transistor TFT, and the data line DL may be electrically connected to the source S of the transistor TFT, where the scan line SL and the data line DL may be respectively used for providing scan signals and data signals to the corresponding transistor TFT for operating the modulation unit AU, but the disclosure is not limited thereto. In addition, in the embodiment, the data line DL may be electrically connected to the first electrode C1 through the transistor TFT.

In some embodiments, a material of the semiconductor layer SE includes low temperature polysilicon (LTPS), metal oxide, amorphous silicon (a-Si), or a combination thereof, but the disclosure is not limited thereto. For example, the material of the semiconductor layer SE may include, but is not limited to, amorphous silicon, polysilicon, germanium, compound semiconductors (for example, gallium nitride, silicon carbide, gallium arsenide, gallium phosphide, indium phosphide, indium arsenide and/or or indium antimonide), alloy semiconductors (such as SiGe alloy, GaAsP alloy, AlInAs alloy, AlGaAs alloy, GaInAs alloy, GaInP alloy, GaInAsP alloy), or a combination thereof. The material of the semiconductor layer SE may also include, but is not limited to, metal oxides, such as indium gallium zinc oxide (IGZO), indium zinc oxide (IZO), indium gallium zinc oxide (IGZTO), or organic semiconductors containing polycyclic aromatic compounds, or a combination thereof. The gate G at least partially overlaps the semiconductor layer SE in the top view direction n of the substrate SB, for example. The source S and the drain D are, for example, separated from each other, and cover at least a part of the semiconductor layer SE and are electrically connected with the semiconductor layer SE. Alternatively, the source S and the drain D may be electrically connected to each other respectively through a via (not shown) in an insulating layer (not shown) between the source S/the drain D and the semiconductor layer SE. It should be noted that the transistor TFT is a bottom gate type thin-film transistor known to those skilled in the art. However, although the embodiment takes the bottom gate type thin-film transistor as an example, the disclosure is not limited thereto.

The common line CL is, for example, disposed on the substrate SB. In some embodiments, the common line CL and the scan line SL extend in the same direction, i.e., the common line CL extends in the first direction d1, but the disclosure is not limited thereto. In the embodiment, the common line CL, the gate G and the scan line SL belong to a same metal layer, where the common line CL is partially covered by the insulating layer IL1, but the disclosure is not limited thereto. The common line CL is, for example, electrically connected to the modulation unit AU to provide a common signal to the modulation unit AU. In the embodiment, the common line CL may be electrically connected to the modulation unit AU through a via V2 penetrating through the insulating layer IL1 and the insulating layer IL2. In detail, the via V2 penetrates through the insulating layer IL 1 and the insulating layer IL2 in the top view direction n of the substrate SB, and exposes a part of the common line CL, where the second electrode C2 is electrically connected to the common line CL through the via V2, so that the modulation unit AU set on the second electrode C2 may be electrically connected to the common line CL.

The driving circuit DC is, for example, disposed on the substrate SB. In some embodiments, the driving circuit DC may be disposed on at least one side of the substrate SB. In detail, the driving circuit DC may be set in a peripheral area (not shown) of the substrate SB, but the disclosure is not limited thereto. For example, as shown in FIG. 1A, the driving circuit DC is at least set in the peripheral area on one side of the substrate SB, but the disclosure is not limited thereto. In some embodiments, the driving circuit DC is set by directly setting the driving circuit on a substrate SB1; or the driving circuit DC is set by setting a chip on the substrate SB1, which is not limited by the disclosure. The driving circuit DC may, for example, include a timing control circuit, a data driving circuit, a voltage supply circuit, a power supply driving circuit, other suitable circuits or a combination thereof, which is not limited by the disclosure. In the embodiment, the driving circuit DC is respectively electrically connected to the scan line SL, the data line DL and the common line CL (the driving circuit electrically connected to the data line DL is not shown in FIG. 1A), where the driving circuit DC may provide the corresponding scan signal and data signal to the transistor TFT through the scan line SL and the data line DL, and the driving circuit DC may also provide the corresponding common signal to the modulation unit AU through the common line CL, so that the modulation unit AU may be operated based on respective voltage levels provided by the transistor TFT and the common line CL, so as to achieve an effect of multi-frequency operation and/or broadband operation.

The heat dissipation structure TC is, for example, disposed below the substrate SB. In detail, the heat dissipation structure TC is disposed below the substrate SB in the top view direction n of the substrate SB. The heat dissipation structure TC may be used, for example, to dissipate heat generated by the electronic components (such as the transistor TFT, the modulation unit AU, the scan line SL, the data line DL, etc.) disposed above the substrate SB to the outside, so as to achieve an effect of reducing a temperature of the modulation device 10a. In some embodiments, the heat dissipation structure TC may include a heat sink having multiple heat dissipation fins to quickly dissipate the aforementioned heat to the outside. In some other embodiments, the heat dissipation structure TC may include a vapor chamber, which has a chamber including microstructures, and the chamber includes a heat absorption end and a heat release end, and a working fluid flows in the chamber. When the aforementioned heat is conducted to the heat absorption end of the chamber, the working fluid absorbs the heat and vaporizes, and due to increase in pressure, the vaporized working fluid moves to the heat release end with a lower pressure, and condenses back to liquid to release heat at the heat release end, thereby dissipating the aforementioned heat to the outside. Thereafter, the liquid may return to the heat absorption end through a capillary phenomenon of the microstructure.

In the embodiment, by configuring the heat dissipation structure TC, an impedance of the scan line SL and/or the data line DL during operation may be reduced, where the scan line SL and/or the data line DL may be, for example, conformed to a following relationship: R = (ρ·L)/A', where ρ is a resistivity of the scan line SL and/or the data line DL, L is a length of the scan line SL in the first direction d1 and/or a length of the data line DL in the second direction d2, and A' is a sectional area of the scan line SL in the second direction d2 and/or a sectional area of the data line DL in the first direction d1.

In some embodiments, as shown in FIG. 1B, the heat dissipation structure TC is disposed below the substrate SB to dissipate the heat generated by the electronic components disposed above the substrate SB to the outside, so that a temperature of the scan line SL and/or the data line DL may be reduced to reduce the resistivity thereof, thereby reducing the impedance of the scan line SL and/or the data line DL.

The conductor layer M is, for example, disposed between the heat dissipation structure TC and the substrate SB. In detail, the conductor layer M is disposed between the heat dissipation structure TC and the substrate SB in the top view direction n of the substrate SB. A material of the conductor layer M may include, for example, copper, molybdenum, graphite, other suitable conductors, or a combination thereof, and the conductor layer M may include, for example, a single-layer structure or a multi-layer structure, but the disclosure is not limited thereto. The conductor layer M may be used, for example, to conduct the heat generated by various electronic components (for example, the transistor TFT, the modulation unit AU, the scan line SL, the data line DL, etc.) disposed above the substrate SB to the heat dissipation structure TC, so as to reduce the temperature of the modulation device 10a, but the disclosure is not limited thereto. In other embodiments, the conductor layer M may be used for electrical conduction. For example, the conductor layer M may include a ground plate, and a material of the ground plate may include, for example, metal, which may be electrically connected with the modulation unit AU to ground the modulation unit AU. The conductor layer M may, for example, have a property of light tight, and may be entirely formed below the substrate SB or may have an opening for shielding undesired electromagnetic waves, but the disclosure is not limited thereto.

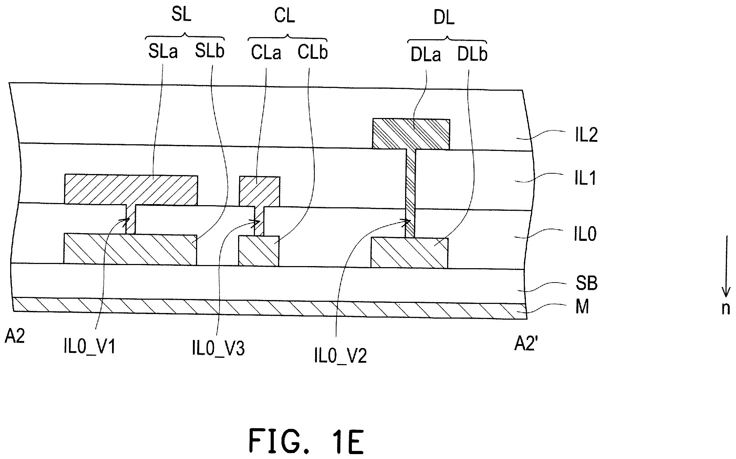

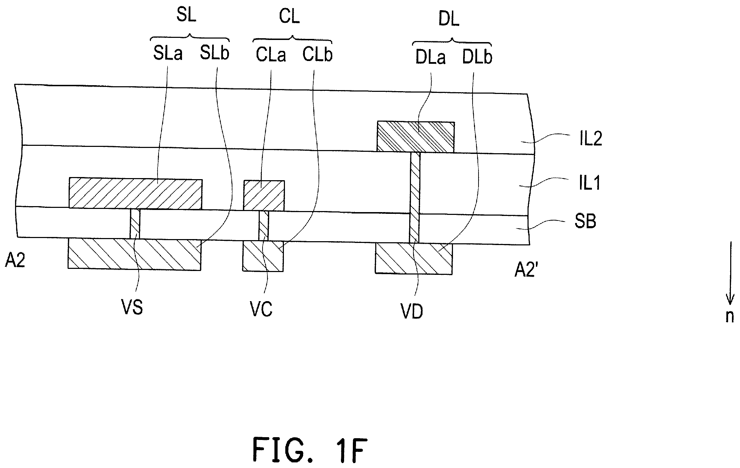

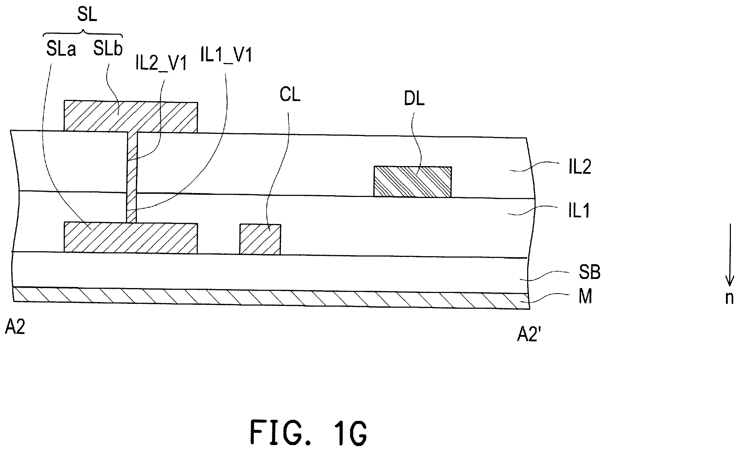

FIG. 1E is a schematic cross-sectional view of an embodiment viewing along a section line A2-A2' of FIG. 1A. FIG. 1F is a schematic cross-sectional view of another embodiment viewing along the section line A2-A2' of FIG. 1A. FIG. 1G is a schematic cross-sectional view of still another embodiment viewing along the section line A2-A2' of FIG. 1A.

Referring to FIG. 1E, the embodiment may further include an insulating layer IL0. The insulating layer IL0 is, for example, disposed on the substrate SB, and is disposed between the substrate SB and the insulating layer IL1. A material of the insulating layer IL0 may be the same as or similar to the material of the insulating layer IL1, and detail thereof is not repeated. In addition, the scan line SL and/or the data line DL in the embodiment may include an auxiliary electrode line. In detail, as shown in FIG. 1E, the scan line SL includes a main electrode line SLa and an auxiliary electrode line SLb, and the data line DL includes a main electrode line DLa and an auxiliary electrode line DLb, where the auxiliary electrode line SLb and the auxiliary electrode line DLb are partially covered by the insulating layer IL0. The main electrode line SLa and the main electrode line DLa are disposed on the insulating layer IL0 and are respectively electrically connected to the auxiliary electrode line SLb and the auxiliary electrode line DLb by penetrating through a via IL0_V1 and a via IL0_V2 of the insulating layer IL0.

Through the aforementioned design, the cross-sectional area of the scan line SL in the second direction d2 and/or the cross-sectional area of the data line DL in the first direction d1 may be increased, thereby reducing the impedance of the scan line SL and/or the data line DL.

In addition, the common line CL may also include an auxiliary electrode line. In detail, as shown in FIG. 1E, the common line CL includes a main electrode line CLa and an auxiliary electrode line CLb, where the auxiliary electrode line CLb is partially covered by the insulating layer IL0, and the main electrode line CLa is disposed on the insulating layer IL0 and is electrically connected to the auxiliary electrode line CLb by penetrating through a via IL0_V3 of the insulating layer IL0.

In some embodiments, a material of the auxiliary electrode line (for example, the auxiliary electrode line SLb, the auxiliary electrode line DLb or/and the auxiliary electrode line CLb) and a material of the main electrode line (for example, the main electrode line SLa, the main electrode line DLa or/and the main electrode line CLa) may be different, in addition, a material resistivity of the auxiliary electrode line (for example, the auxiliary electrode line SLb, the auxiliary electrode line DLb or/and the auxiliary electrode line CLb) may be lower than a material resistivity of the main electrode line (for example, the main electrode line SLa, the main electrode line DLa or/and the main electrode line CLa), but the disclosure is not limited thereto. In some other embodiments, a thickness of the auxiliary electrode line (for example, the auxiliary electrode line SLb, the auxiliary electrode line DLb or/and the auxiliary electrode line CLb) in the top view direction n may be larger than a thickness of the main electrode line (for example, the main electrode line SLa, the main electrode line DLa or/and the main electrode line CLa), but the disclosure is not limited thereto. In some other embodiments, in a cross-sectional direction, the thickness of the auxiliary electrode line (for example, the auxiliary electrode line SLb, the auxiliary electrode line DLb or/and the auxiliary electrode line CLb) may be larger than the thickness of the main electrode line (for example, the main electrode lines SLa, the main electrode line DLa or/and the main electrode line CLa), but the disclosure is not limited thereto.

However, the pattern of the scan line SL and/or the data line DL is not limited to the embodiment shown in FIG. 1E. FIG. 1F and FIG. 1G illustrate other patterns of the scan line SL and/or the data line DL.

Referring to FIG. 1F, FIG. 1F illustrates that the scan line SL and/or the data line DL of the embodiment include an auxiliary electrode line. In detail, as shown in FIG. 1F, the scan line SL includes the main electrode line SLa and the auxiliary electrode line SLb, and the data line DL includes the main electrode line DLa and the auxiliary electrode line DLb, where the auxiliary electrode line SLb and the auxiliary electrode line DLb are disposed below the substrate SB, and the main electrode line SLa and the main electrode line DLa are disposed above the substrate SB and are respectively electrically connected to the auxiliary electrode line SLb and the auxiliary electrode line DLb by penetrating through a via VS and a via VD of the substrate SB.

Through the above design, a cross-sectional area of the scan line SL in the second direction d2 and/or a cross-sectional area of the data line DL in the first direction d1 may be increased, thereby reducing the impedance of the scan line SL and/or the data line DL.

In addition, the common line CL may also include an auxiliary electrode line. In detail, as shown in FIG. 1F, the common line CL includes the main electrode line CLa and the auxiliary electrode line CLb, where the auxiliary electrode line CLb is disposed below the substrate SB, and the main electrode line CLa is disposed above the substrate SB and is electrically connected to the auxiliary electrode line CLb by penetrating through a via VC of the substrate SB.

Referring to FIG. 1G, which shows that the scan line SL of the embodiment includes the main electrode line SLa and the auxiliary electrode line SLb, where the main electrode line SLa is disposed on the substrate SB, and the auxiliary electrode line SLb is disposed on the insulating layer IL2 and is electrically connected to the main electrode line SLa by penetrating through a via IL2_V1 of the insulating layer IL2 and a via IL_1V1 of the insulating layer IL1, where the via IL2_V1 is communicated with the via IL1_V1.

Through the aforementioned design, a cross-sectional area of the scan line SL in the second direction d2 may be increased, thereby reducing the impedance of the scan line SL.

However, it should be noted that the pattern of the scan line SL and/or the data line DL is not limited to the embodiments shown in FIG. 1E to FIG. 1G. For example, the scan line SL and/or the data line DL may, for example, have a thickness of more than 1 µm in the top view direction n of the substrate SB; or the scan line SL and/or the data line DL may be composed of a multi-layer structure, such that a cross-sectional area of the scan line SL in the second direction d2 and/or a cross-sectional area of the data line DL in the first direction d1 may be relatively increased, thereby reducing the impedance of the scan line SL and/or the data line DL.

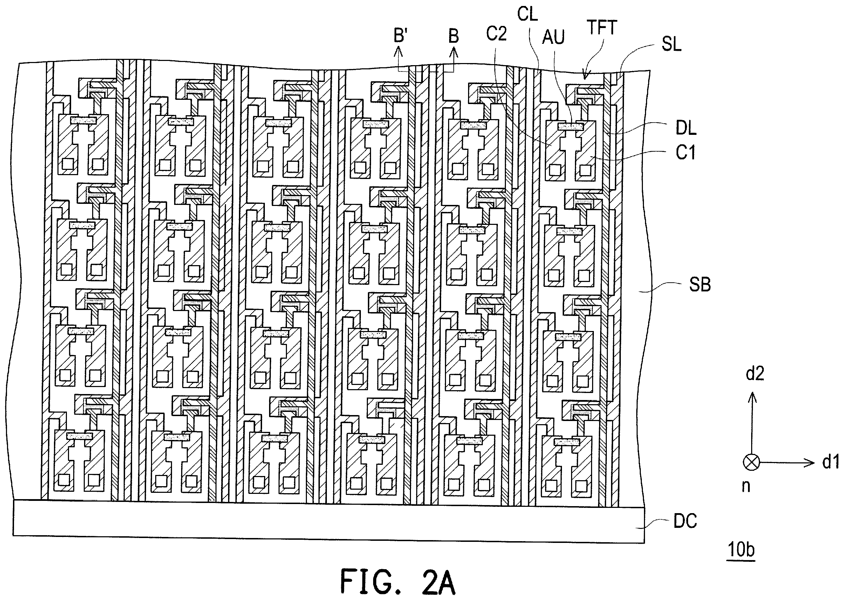

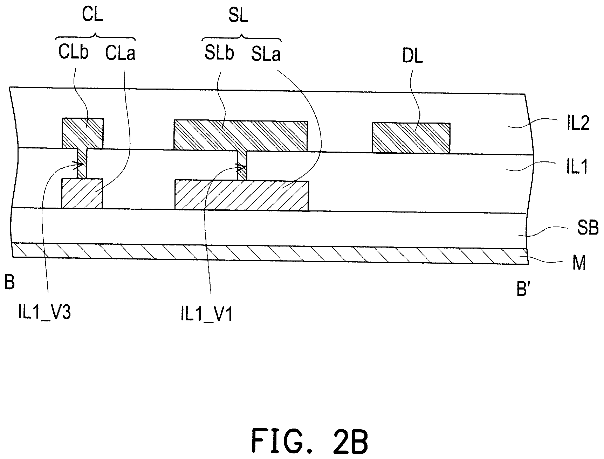

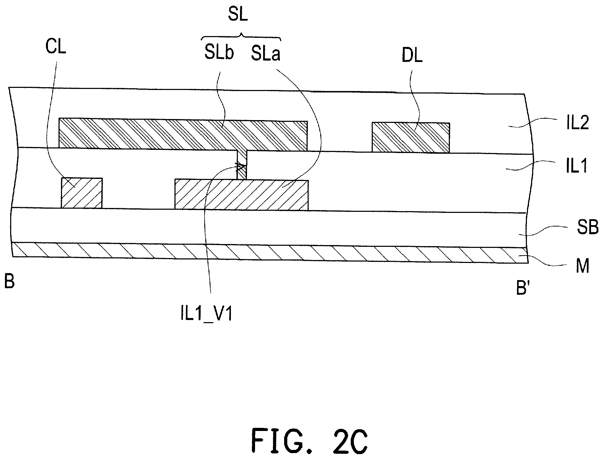

FIG. 2A is a partial schematic top view of a modulation device according to a second embodiment of the disclosure. FIG. 2B is a schematic cross-sectional view of an embodiment viewing along a section line B-B' of FIG. 2A. FIG. 2C is a schematic cross-sectional view of another embodiment viewing along the section line B-B' of FIG. 2A. It should be noted that the referential numbers of the components and a part of contents of the embodiment of FIG. 1A may also be used in the embodiment of FIG. 2A, and the referential numbers of the components and a part of contents of the embodiments of FIG. 1E to FIG. 1G may also be used in the embodiments of FIG. 2B and FIG. 2C, where the same referential numbers denote the same or like components, and descriptions of the same technical contents are omitted.

Referring to FIG. 2A, a main difference between a modulation device 10b of the embodiment and the modulation device 10a described above is that the scan lines SL included in the modulation device 10b are disposed in parallel with the data lines DL, i.e., the scan lines SL included in the modulation device 10b extend toward the second direction d2. The maximum length of the modulation device 10b in the second direction d2 is smaller than the maximum length in the first direction d1. Therefore, compared with the arrangement that the scan lines SL extend toward the first direction d1, the scan lines SL included in the modulation device 10b are shorter in length.

Through the aforementioned design, the scan line SL may have a relatively short length in the second direction d2, thereby reducing the impedance of the scan line SL.

In addition, the common line CL of the embodiment may also extend in the second direction d2.

In FIG. 2B and FIG. 2C, other patterns of the scan line SL are shown.

Referring to FIG. 2B and FIG. 2C, which illustrate that the scan line SL of the embodiment includes an auxiliary electrode line. In detail, as shown in FIG. 2B, the scan line SL includes the main electrode line SLa and the auxiliary electrode line SLb, where the main electrode line SLa is disposed on the substrate SB and is partially covered by the insulating layer IL1, and the auxiliary electrode line SLb is disposed on the insulating layer IL1 and is electrically connected to the main electrode line SLa by penetrating through the via IL1_V1 of the insulating layer IL1. In addition, the auxiliary electrode line SLb and the data line DL in the embodiment belong to a same metal layer, but the disclosure is not limited thereto. Referring to FIG. 2B and FIG. 2C, in FIG. 2B, the auxiliary electrode line SLb of the scan line SL does not overlap the common line CL; and in FIG. 2C, the auxiliary electrode line SLb of the scan line SL overlaps the common line CL.

Through the aforementioned design, the cross-sectional area of the scan line SL in the second direction d2 may be increased, thereby reducing the impedance of the scan line SL.

In addition, in the embodiment of FIG. 2B, the common line CL may also include an auxiliary electrode line. In detail, as shown in FIG. 2B, the common line CL includes the main electrode line CLa and the auxiliary electrode line CLb, where the main electrode line CLa is provided on the substrate SB and is partially covered by the insulating layer IL1, and the auxiliary electrode line CLb is disposed on the insulating layer IL1, and is electrically connected to the main electrode line CLa by penetrating through a via IL1_V3 of the insulating layer IL1. In addition, the auxiliary electrode line CLb and the data line DL in the embodiment also belong to a same metal layer, but the disclosure is not limited thereto.

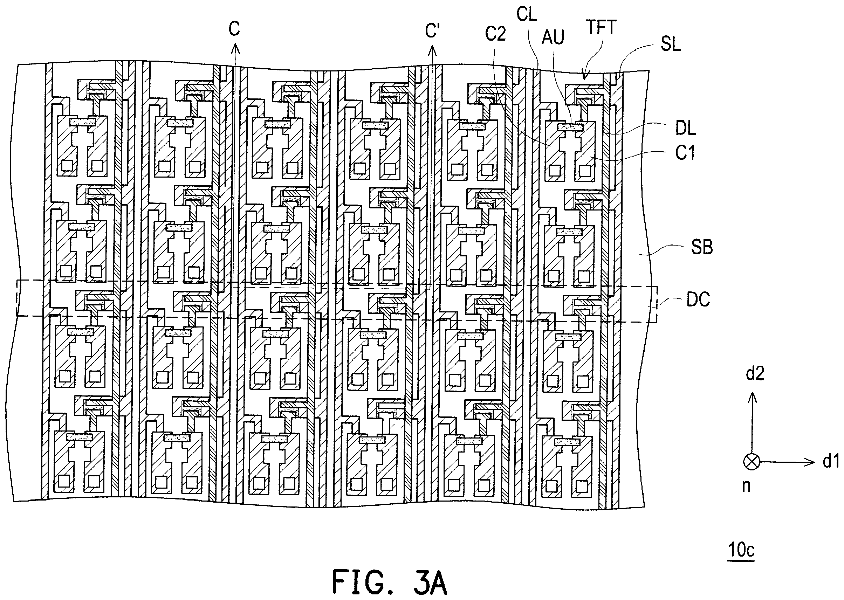

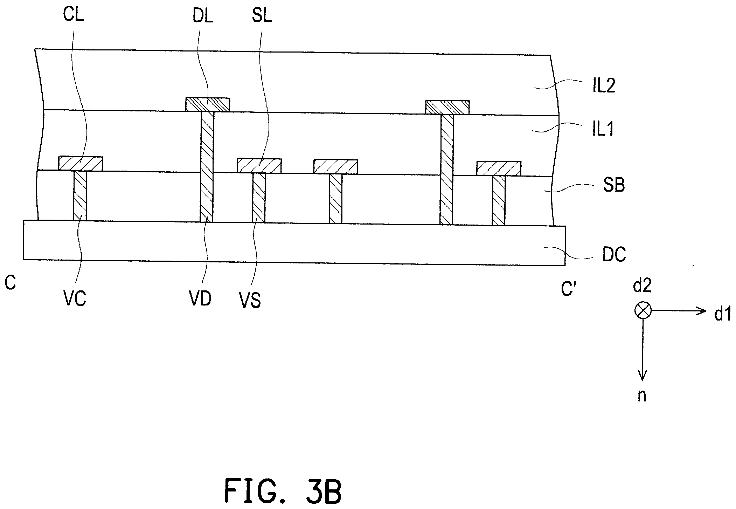

FIG. 3A is a partial schematic top view of a modulation device according to a third embodiment of the disclosure, and FIG. 3B is a schematic cross-sectional view of an embodiment viewing along a section line C-C' of FIG. 3A. It should be noted that the referential numbers of the components and a part of contents of the embodiment of FIG. 2A may also be used in the embodiment of FIG. 3A, where the same referential numbers denote the same or like components, and descriptions of the same technical contents are omitted.

Referring to FIG. 3A and FIG. 3B at the same time, a main difference between a modulation device 10c of the embodiment and the modulation device 10b is that the driving circuit DC of the modulation device 10c is disposed below the substrate SB, and the driving circuit DC is substantially disposed in a middle area of the substrate SB.

In detail, the driving circuit DC is provided below the substrate SB. The driving circuit DC of the embodiment is electrically connected to the scan line SL, the data line DL, and the common line CL through the via VS, the via VD, and the via VC, respectively, where the via VS and the via VC penetrate through the substrate SB and the via VD penetrates through the insulating layer IL1 and the substrate SB. In some embodiments, the conductor layer M may be disposed between the substrate SB and the driving circuit DC, and the driving circuit DC may be respectively electrically connected to the scan line SL, the data line DL or/and the common line CL by penetrating through multiple vias of the substrate SB and the conductor layer M, but the disclosure is not limited thereto.

Based on the above, in the modulation device 10c, the driving circuit DC is disposed below the substrate SB. Therefore, compared with the arrangement that the driving circuit DC is disposed on at least one side of the substrate SB, the scan line SL and/or the data line DL of the modulation device 10c have shorter lengths.

Through the aforementioned design, the scan line SL and/or the data line DL may have relatively short lengths in the second direction d2, thereby reducing the impedance of the scan line SL and/or the data line DL.

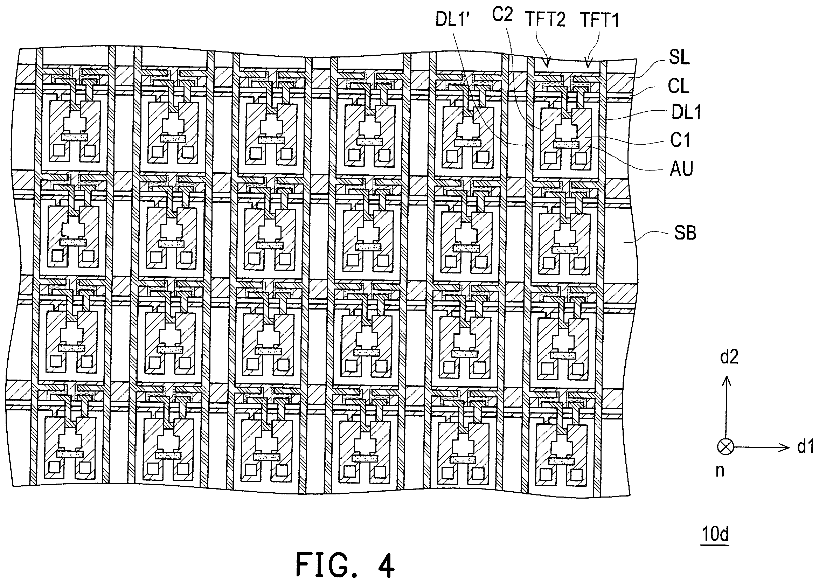

FIG. 4 is a partial schematic top view of a modulation device according to a fourth embodiment of the disclosure. It should be noted that the referential numbers of the components and a part of contents of the embodiment of FIG. 1A may also be used in the embodiment of FIG. 4, where the same referential numbers denote the same or like components, and descriptions of the same technical contents are omitted.

Referring to FIG. 4, a main difference between a modulation device 10d of the embodiment and the aforementioned modulation device 10a is that one modulation unit AU of the modulation device 10d is operated by two transistors and includes two data lines.

In detail, the modulation device 10d includes a first transistor TFT1 and a second transistor TFT2 used for operating one modulation unit AU, and the data line DL includes a main data line DL1 and an auxiliary data line DL1'. The main data line DL1 may be, for example, electrically connected to the first transistor TFT1, and the auxiliary data line DL1' may be, for example, electrically connected to the second transistor TFT2, so as to respectively provide corresponding data signals, and the first transistor TFT1 and the second transistor TFT2 are used to operate the modulation unit AU, but the disclosure is not limited thereto. In some embodiments, when a voltage or current taken by the main data line DL1 is too large, the auxiliary data line DL1' may be used to share the load, but the disclosure is not limited thereto.

It should be noted that the modulation device 10d (or the aforementioned modulation device 10a, the modulation device 10b, or the modulation device 10c) of the embodiment may also include two scan lines (not shown), which include a main scan line and an auxiliary scan line, where the main scan line and the auxiliary scan line are respectively electrically connected to the corresponding transistors, but the disclosure is not limited thereto.

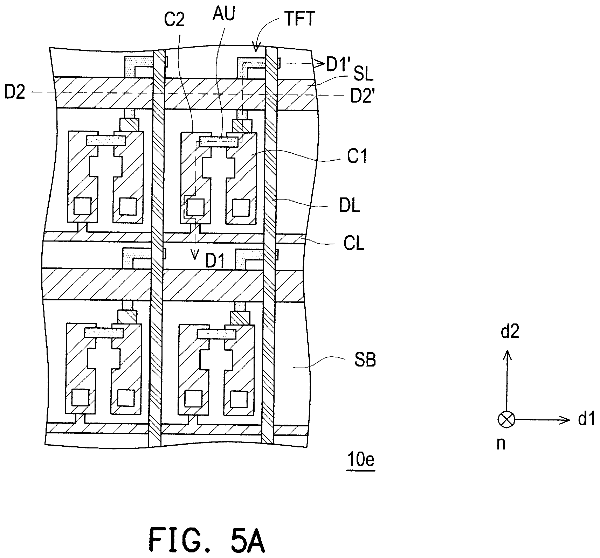

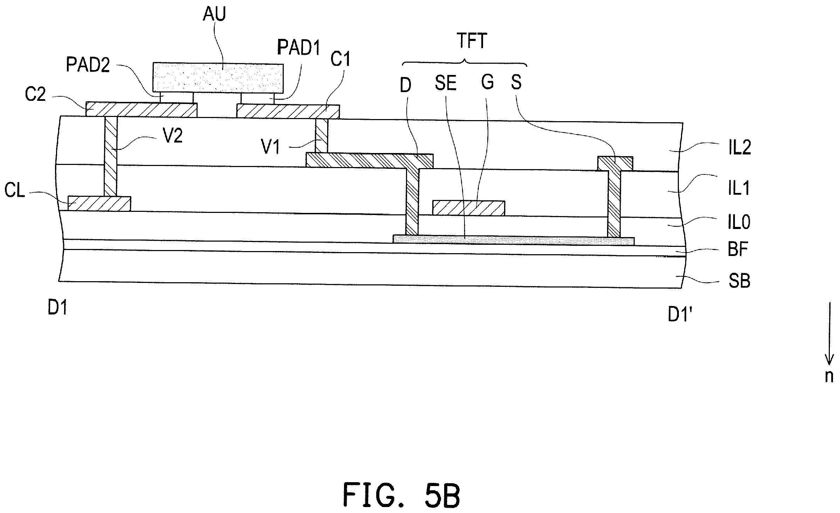

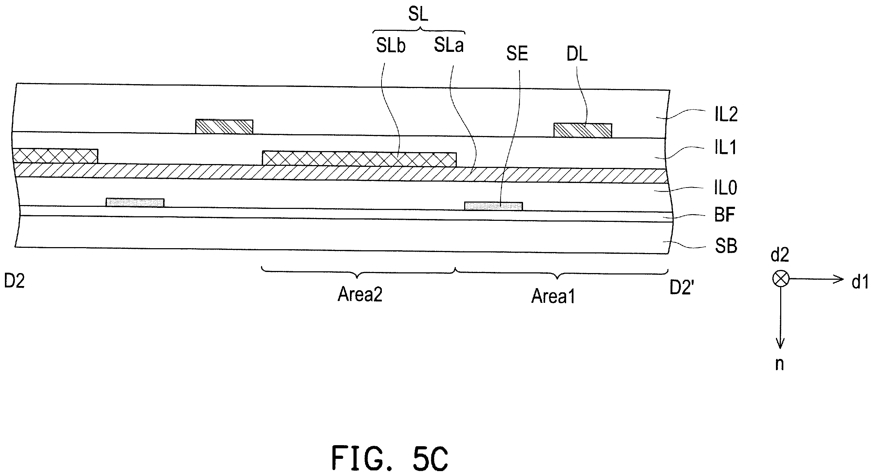

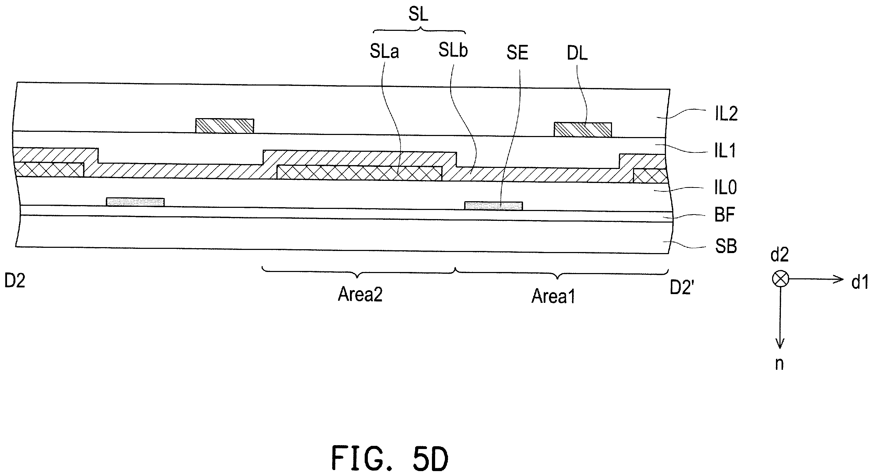

FIG. 5A is a partial schematic top view of a modulation device according to a fifth embodiment of the disclosure. FIG. 5B is a schematic cross-sectional view of an embodiment viewing along a section line D1-D1' of FIG. 5A. FIG. 5C is a schematic cross-sectional view of an embodiment viewing along a section line D2-D2' of FIG. 5A. FIG. 5D is a schematic cross-sectional view of another embodiment viewing along the section line D2-D2' of FIG. 5A. It should be noted that the referential numbers of the components and a part of contents of the embodiment of FIG. 1A may also be used in the embodiment of FIG. 5A, the referential numbers of the components and a part of contents of the embodiment of FIG. 1B may also be used in the embodiment of FIG. 5B, and the referential numbers of the components and a part of contents of the embodiments of FIG. 1E to FIG. 1G may also be used in the embodiments of FIG. 5C and FIG. 5D, where the same referential numbers denote the same or like components, and descriptions of the same technical contents are omitted.

Referring to FIG. 5A and FIG. 5B at the same time, a main difference between a modulation device 10e of the embodiment and the aforementioned modulation device 10a is that the transistor TFT in the modulation device 10c is a top gate type thin-film transistor, and a material of the semiconductor layer SE in the transistor TFT is low temperature polysilicon.

In the embodiment, the modulation device 10e further includes a buffer layer BF and an insulating layer IL0.

The buffer layer BF is, for example, disposed on the substrate SB, and the semiconductor layer SE is, for example, disposed on the buffer layer BF. In the embodiment, the buffer layer BF is disposed between the substrate SB and the semiconductor layer SE, but the disclosure is not limited thereto. A material of the buffer layer BF may be, for example, an inorganic material (for example, silicon oxide, silicon nitride, silicon oxynitride, or a stacked layer of at least two of the above-mentioned materials), but the disclosure is not limited thereto. The buffer layer BF may be, for example, used to reduce impurities in the substrate SB from entering the semiconductor layer SE, and may be, for example, used to enhance adhesion between the substrate SB and the semiconductor layer SE, but the disclosure is not limited thereto.

The insulating layer IL0 is, for example, disposed on the buffer layer BF and partially covers the semiconductor layer SE. A material of insulating layer IL0 may be the same or similar to that of the insulating layer IL1, and detail thereof is not repeated.

In some embodiments, the semiconductor layer SE may include a source electrode region, a drain electrode region and a channel region (not shown), where the source electrode region contacts the source S, the drain electrode region contacts the drain D, and the channel region and the gate G overlap each other in the top view direction n of the substrate SB. In addition, the modulation device 10e may further include a light shielding layer (not shown), the light shielding layer may be, for example, disposed between the substrate SB and the channel region of the semiconductor layer SE and may be covered by the buffer layer BF, and the light shielding layer at least partially overlaps the channel region of the semiconductor layer SE in the top view direction n of the substrate SB, thereby reducing a situation that the channel region is affected and degraded by external ambient light irradiation. In some embodiments, a material of the light shielding layer may be a material with a transmittance lower than 30%, but the disclosure is not limited thereto.

Referring to FIG. 5C and FIG. 5D, the scan line SL of the embodiment may include an auxiliary electrode line.

In detail, in an embodiment, as shown in FIG. 5C, the scan line SL includes the main electrode line SLa and the auxiliary electrode line SLb, where the auxiliary electrode line SLb is located on the main electrode line SLa. From another point of view, the modulation device 10c may include an area Area1 and an area Area2, and the area Area1 and the area Area2 are adjacent to each other in the first direction d1, where the area Area2 is defined as an area that does not overlap the data line DL or the semiconductor layer SE in the top view direction n of the substrate SB, and the area Area1 is an area other than the area Area2. The main electrode line SLa is, for example, distributed in the areas Area1 and Area2, and the auxiliary electrode line SLb is, for example, distributed in the area Area2. Therefore, through the aforementioned design, a cross-sectional area of the scan line SL in the area Area2 in the second direction d2 may be increased, thereby reducing the impedance of the scan line SL.

In another embodiment, as shown in FIG. 5D, the main electrode line SLa included in the scan line SL is located on the auxiliary electrode line SLb, where the main electrode line SLa is, for example, distributed in the area Area1 and the area Area2, and the auxiliary electrode line SLb is distributed in the area Area2. Therefore, through the aforementioned design, the cross-sectional area of the scan line SL in the area Area2 in the second direction d2 may be increased, thereby reducing the impedance of the scan line SL.

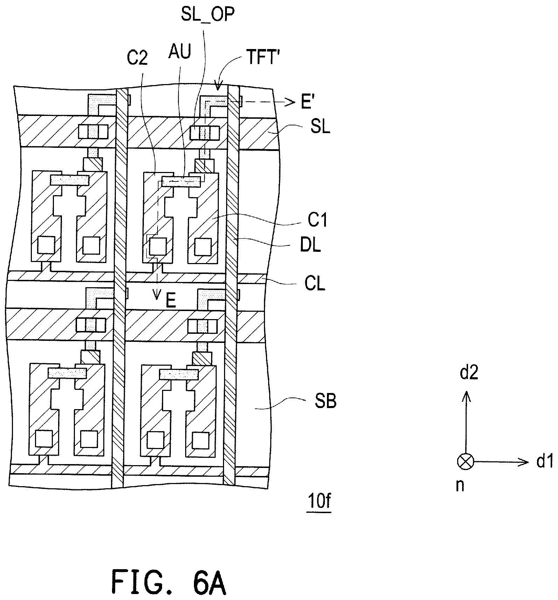

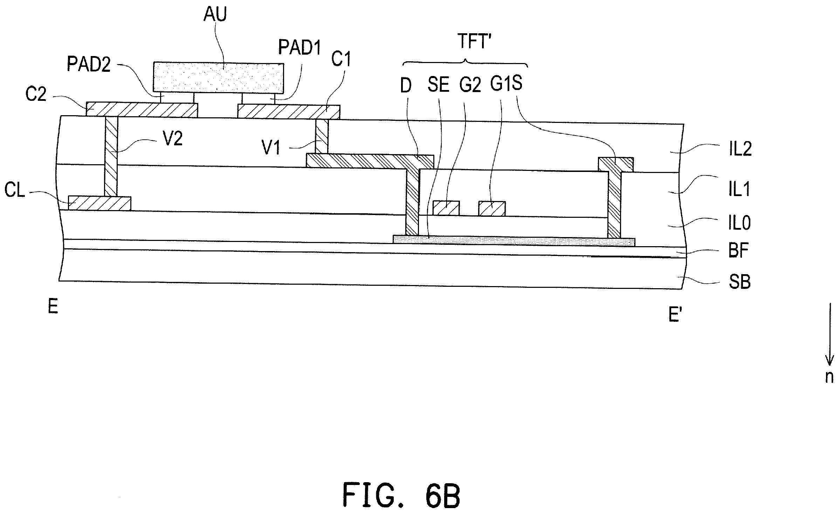

FIG. 6A is a partial schematic top view of a modulation device according to a sixth embodiment of the disclosure, and FIG. 6B is a schematic cross-sectional view of an embodiment viewing along a section line E-E' of FIG. 6A. It should be noted that the referential numbers of the components and a part of contents of the embodiment of FIG. 5A may also be used in the embodiment of FIG. 6A, and the referential numbers of the components and a part of contents of the embodiment of FIG. 5B may also be used in the embodiment of FIG. 6B, where the same referential numbers denote the same or like components, and descriptions of the same technical contents are omitted.

Referring to FIG. 6A and FIG. 6B at the same time, a main difference between a modulation device lOf of the embodiment and the aforementioned modulation device 10e is that a transistor TFT' in the modulation device 10f is a double-gate type thin-film transistor.

In detail, in the embodiment, the scan line SL has an opening SL_OP, where the opening SL OP of the scan line SL exposes a part of the semiconductor layer SE in the top view direction n of the substrate SB, thereby forming the transistor TFT' with double gates (a gate G1 and a gate G2) separated from each other.

Although not shown in FIG. 6A, in some embodiments, the opening SL_OP of the scan line SL may extend along the first direction d1 to partially overlap with the data line DL in the top view direction n of the substrate SB, thereby reducing an overlapping area of the scan line SL and the data line DL in the top view direction n of the substrate SB.

Through the above design, the overlapping area of the scan line SL and the data line DL in the top view direction n of the substrate SB may be reduced, so that the capacitance loading generated by the scan line SL and the data line DL may be reduced, thereby improving the signal transmission quality of the modulation device 10f.

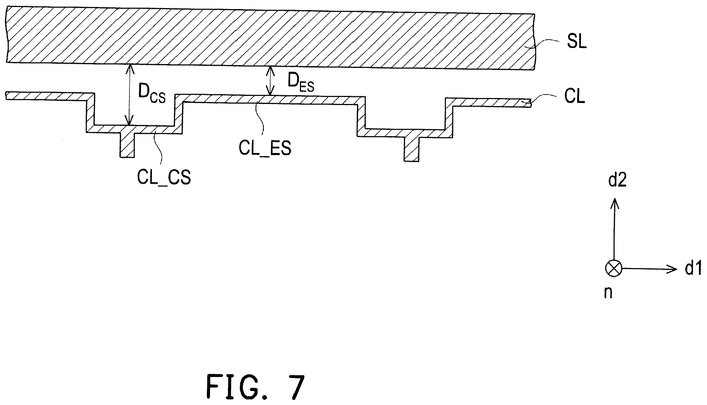

FIG. 7 is a partial schematic top view of an arrangement relationship between the scan line and the common line in a modulation device according to an embodiment of the disclosure.

In some embodiments, as shown in FIG. 7, the common line CL has an electrical connection segment CL_CS and an extension segment CL_ES. The electrical connection segment CL_CS of the common line CL is, for example, used for electrical connection with the modulation unit AU. In addition, the extension segment CL_ES of the common line CL extends, for example, in an extending direction (the first direction d1 in the embodiment) of the common line CL, and two ends thereof are connected to the adjacent electrical connection segments CL_CS. In the embodiment, the electrical connection segment CL_CS of the common line CL is relatively far away from the scan line SL, i.e., a distance Dcs between the electrical connection segment CL_CS of the common line CL and the scan line SL in the second direction d2 is greater than a distance D_{ES} between the extension segment CL_ES of the common line CL and the scan line SL in the second direction d2.

Through the above design, the distance between the common line CL and the scan line SL in the second direction d2 may be increased, so that the capacitance loading generated by the common line CL and the scan line SL may be reduced.

It should be noted that, in other embodiments, the extension segment CL_ES of the common line CL may also be relatively far away from the scan line SL, i.e., the distance Des between the electrical connection segment CL_CS of the common line CL and the scan line SL in the second direction d2 is smaller than the distance D_{ES} between the extension segment CL_ES of the common line CL and the scan line SL in the second direction d2, but the disclosure is not limited thereto.

In addition, in other embodiments, a distance between the common line CL used for driving one row and the scan line SL used for driving an adjacent row in the second direction d2 may also be increased, but the disclosure is not limited thereto.

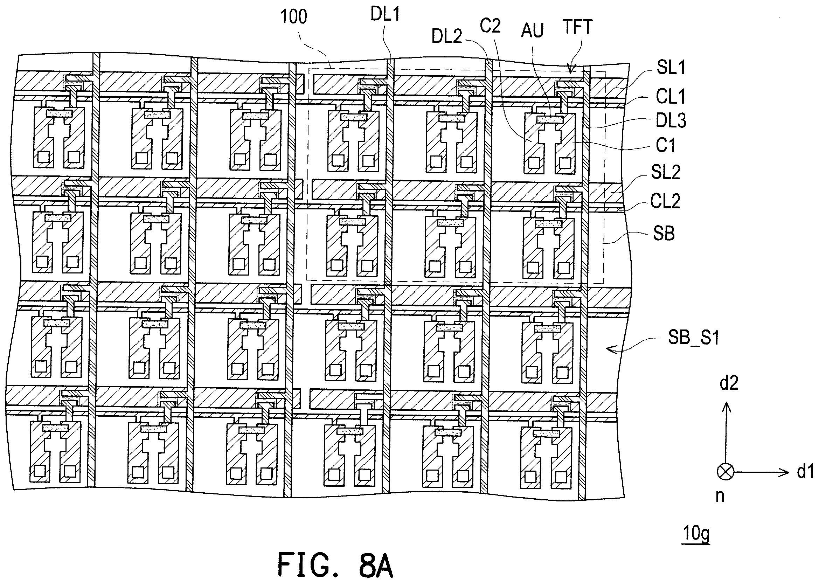

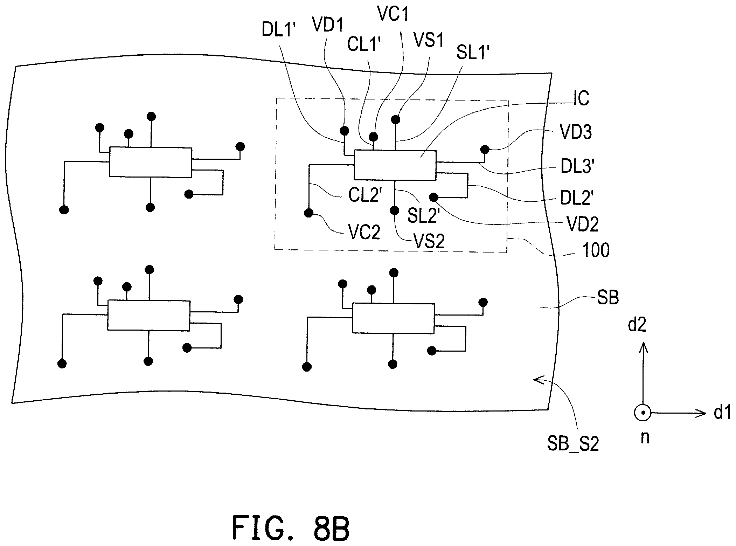

FIG. 8A is a partial schematic top view of a modulation device according to a seventh embodiment of the disclosure, and FIG. 8B is a partial schematic top view of a driving circuit of the modulation device of FIG. 8A. It should be noted that the referential numbers of the components and a part of contents of the embodiment of FIG. 3A may also be used in the embodiment of FIG. 8A, and the referential numbers of the components and a part of contents of the embodiment of FIG. 3B may also be used in the embodiment of FIG. 8B, where the same referential numbers denote the same or like components, and descriptions of the same technical contents are omitted.

Referring to FIG. 8A, a main difference between a modulation device lOg of the embodiment and the aforementioned modulation device 10c is that the modulation device 10g includes multiple chips IC disposed below the substrate SB, and the chips IC drive multiple modulation units AU in a partition manner.

In detail, the modulation device 10g of the embodiment divides m*n modulation units AU into one modulation unit group 100, where the m*n modulation units AU are disposed in an array, and m modulation units AU are disposed in the first direction d1, and n modulation units AU are disposed in the second direction d2. Therefore, on a first surface SB_S1 of the substrate SB (the surface provided with the modulation units AU), one modulation unit group 100 includes n scan lines, m data lines and n common lines, and one modulation unit group 100 is driven by one chip IC. Taking FIG. 8A as an example, the modulation device 10g of the embodiment divides 3*2 modulation units AU into one modulation unit group 100, and the modulation units AU are disposed in an array. On the first surface SB_S1 of the substrate SB (the surface provided with the modulation units AU), one modulation unit group 100 includes 2 scan lines (a scan line SL1 and a scan line SL2), 3 data lines (a data line DL1, a data line DL2 and a data line DL3) and two common lines (a common line CL1 and a common line CL2), and one modulation unit group 100 is driven by one chip IC.

The chip IC may include, for example, a timing control circuit, a data driving circuit, a voltage supply circuit, a power driving circuit, other suitable circuits, or a combination thereof, but the disclosure is not limited thereto. In the embodiment, the chips may be formed below the substrate SB through a panel level package (PLP) process, where the panel level package may include a re-distributed layer first (RDL first) process or a chip first process. Therefore, the substrate SB of the embodiment may have a panel-level size (i.e., an area of the substrate SB may be greater than or equal to 50 cm×50 cm), which can be used to achieve requirements of high productivity.

In addition, in the embodiment, the substrate SB has the vias, where the chips IC may be electrically connected to the modulation units AU through the vias of the substrate SB. In detail, in one modulation unit group 100, two scan lines (the scan line SL1' and the scan line SL2'), three data lines (the data line DL1', the data line DL2' and the data line DL3'), and two common lines (the common line CL1' and the common line CL2') that are electrically connected to one chip IC are disposed on the second surface SB_S2 of the substrate SB (the surface provided with the chip IC), where the scan line SL1' is electrically connected to the scan line SL1 through the via VS1 of the substrate SB, the scan line SL2' is electrically connected to the scan line SL2 through the via VS2 of the substrate SB, the data line DL1' is electrically connected to the data line DL1 through the via VD1 of the substrate SB, the data line DL2' is electrically connected to the data line DL2 through the via VD2 of the substrate SB, the data line DL3' is electrically connected to the data line DL3 through the via VD3 of the substrate SB, the common line CL1' is electrically connected to the common line CL1 through the via VC1 of the substrate SB, and the common line CL2' is electrically connected to the common line CL2 through the via VC2 of the substrate SB.

Through the aforementioned design, in the modulation device 10g, a length of the scan line SL in the first direction d1 and/or a length of the data line DL in the first direction d1 may be reduced, thereby reducing the impedance of the scan line SL and/or the data line DL.

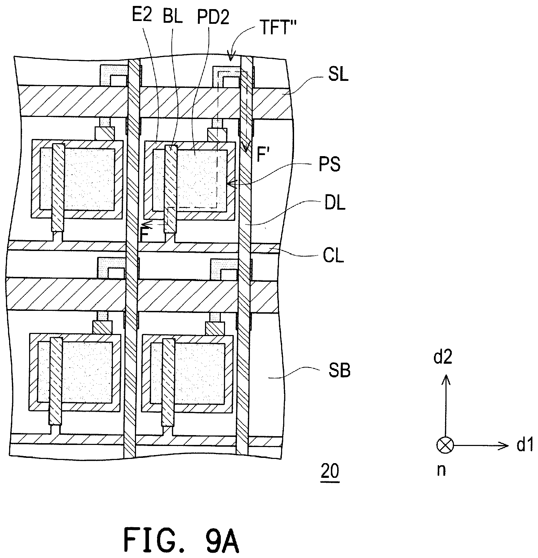

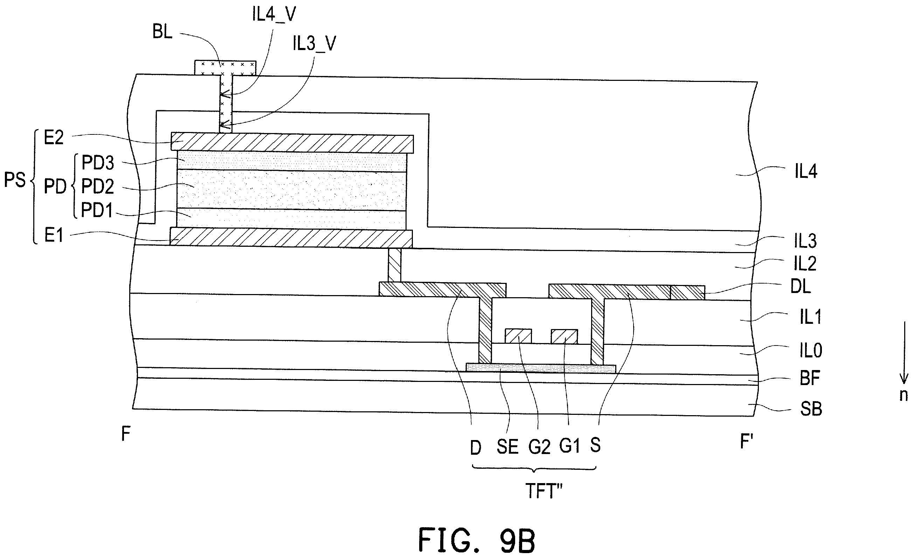

FIG. 9A is a partial schematic top view of a photosensitive device according to an embodiment of the disclosure, and FIG. 9B is a schematic cross-sectional view of an embodiment viewing along a section line F-F' of FIG. 9A. It should be noted that the referential numbers of the components and a part of contents of the embodiment of FIG. 1A may also be used in the embodiment of FIG. 9A, and the referential numbers of the components and a part of contents of the embodiment of FIG. 1B may also be used in the embodiment of FIG. 9B, where the same referential numbers denote the same or like components, and descriptions of the same technical contents are omitted.

Referring to FIG. 9A, a main difference between a photosensitive device 20 of the embodiment and the aforementioned modulation device 10a is that the photosensitive device 20 includes a photoelectric unit PS but does not include the modulation unit AU.

In detail, the photosensitive device 20 includes a photoelectric unit PS, where the photoelectric unit PS includes a photodiode PD, an electrode E1 and an electrode E2. The photodiode PD may include, for example, a semiconductor layer PD1, a photosensitive layer PD2, and a semiconductor layer PD3, and the semiconductor layer PD1, the photosensitive layer PD2, and the semiconductor layer PD3 are, for example, stacked according to the above order in the top view direction n of the substrate SB. The electrode E1 and the electrode E2 are, for example, electrically connected to the semiconductor layer PD1 and the semiconductor layer PD3, respectively. The photodiode PD may include, for example, a single crystal material, a polycrystalline material, or an organic material. For example, the photodiode PD may include, for example, an organic photodiode (OPD), but the disclosure is not limited thereto.

The photoelectric unit PS is, for example, electrically connected to the drain D of a transistor TFT", so that the transistor TFT" may be used to drive the photoelectric unit PS. In detail, the photoelectric unit PS may convert received photons into carriers (such as electrons and/or holes), and the carriers are stored in the photoelectric unit PS when the transistor TFT" is not turned on. After the transistor TFT" is turned on, the carriers stored in the photoelectric unit PS may be, for example, read through a read line (the data line DL) coupled to the transistor TFT", so as to realize the function of light detection. The transistor TFT" in the embodiment is, for example, a double-gate type thin-film transistor (including the gate G1 and the gate G2), and a material thereof is, for example, low temperature polysilicon, but the disclosure is not limited thereto.

In some embodiments, the photosensitive device 20 may further include a buffer layer BF, an insulating layer IL3, an insulating layer IL4 and a bias line BL.

The buffer layer BF is, for example, disposed between the substrate SB and the semiconductor layer SE of the transistor TFT". A material of the buffer layer BF may be, for example, an inorganic material (for example, silicon oxide, silicon nitride, silicon oxynitride, or a stacked layer of at least two of the above materials), but the disclosure is not limited thereto. The buffer layer BF may be, for example, used to reduce impurities in the substrate SB from entering the semiconductor layer SE, and may be, for example, used to enhance the adhesion between the substrate SB and the semiconductor layer SE, but the disclosure is not limited thereto.

The insulating layer IL3 is, for example, disposed on the insulating layer IL2. In the embodiment, the insulating layer IL3 covers the transistor TFT" and partially covers the photoelectric unit PS, where the insulating layer IL3 has a via IL3_V exposing the electrode E2 of the photoelectric unit PS. A material of the insulating layer IL3 may be the same as or similar to the material of the insulating layer IL1, and detail thereof is not described.

The insulating layer IL4 is, for example, disposed on the insulating layer IL3. In the embodiment, the insulating layer IL4 also covers the transistor TFT" and partially covers the photoelectric unit PS, where the insulating layer IL4 has a via IL4_V exposing the electrode E2 of the photoelectric unit PS, i.e., the via IL4_V may be communicated with the via IL3_V to expose a part of the electrode E2 together. A material of the insulating layer IL4 may be the same as or similar to the material of the insulating layer IL1, and detail thereof is not described. In some embodiments, the insulating layer IL4 may be used as a planarization layer, but the disclosure is not limited thereto.

The bias line BL is, for example, disposed on the insulating layer IL4 and is electrically connected to the photoelectric unit PS, where the bias line BL may be, for example, electrically connected to the electrode E2 of the photoelectric unit PS through the communicated vias IL3_V and IL4_V. The bias line BL may be, for example, used to apply a voltage to the photoelectric unit PS to separate hole-electron pairs in the photoelectric unit PS to generate carriers. In some embodiments, the bias line BL may extend toward the second direction d2, but the disclosure is not limited thereto.

In the embodiment, the designs of the scan lines SL and/or the data lines DL applied to the modulation device 10a to the modulation device 10g may also be applied to the photosensitive device 20 to improve light detection quality of the photosensitive device 20. For example, by reducing the overlapping area of the scan line SL and the data line DL in the top view direction n of the substrate SB, the capacitance loading generated by the scan line SL and the data line DL may be reduced; or by making the scan line SL and/or the data line DL to include a stacked layer of the main electrode line and the auxiliary electrode line, the cross-sectional area of the scan line SL in the second direction d2 and/or the cross-sectional area of the data line DL in the first direction d1 may be increased, thereby decreasing the impedance of the scan line SL and/or the data line DL, but the disclosure is not limited thereto.

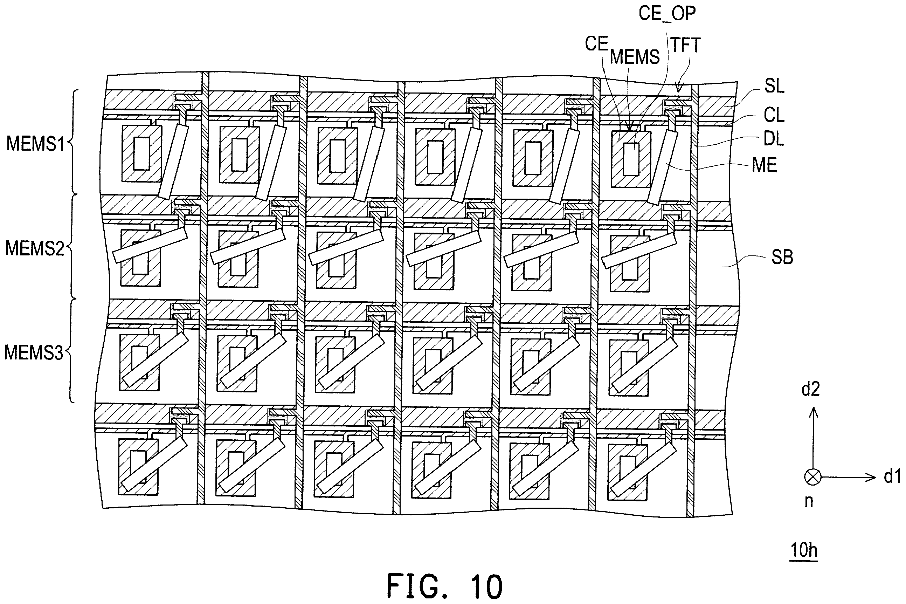

FIG. 10 is a partial schematic top view of a modulation device according to an eighth embodiment of the disclosure. It should be noted that the referential numbers of the components and a part of contents of the embodiment of FIG. 1A may also be used in the embodiment of FIG. 10, where the same referential numbers denote the same or like components, and descriptions of the same technical contents are omitted.

Referring to FIG. 10, a main difference between a modulation device 10h of the embodiment and the aforementioned modulation device 10a is that the modulation device 10h includes a modulation unit MEMS but does not include the modulation unit AU.

In detail, the modulation unit MEMS in the modulation device 10h is, for example, a micro-electromechanical unit, which includes a common electrode CE and a modulation electrode ME. The common electrode CE is, for example, electrically connected to the common line CL to receive a signal coming from the common line CL, and the common electrode CE, for example, has an opening CE_OP, but the disclosure is not limited thereto. The modulation electrode ME is, for example, electrically connected to the transistor TFT, so as to move according to a corresponding signal provided from the transistor TFT. In the embodiment, the modulation electrode ME may receive the corresponding signal provided by the transistor TFT to rotate and move. For example, a group of modulation units MEMS1 of a first row in the modulation device 10h is in a state that the transistor TFT is not turned on, and a group of modulation units MEMS2 in a second row of the modulation device 10h receives a first signal provided by the transistor TFT to rotate and move, and a group of modulation units MEMS3 in a third row of the modulation device 10h receives a second signal provided by the transistor TFT to rotate and move.

By rotating and moving the modulation electrode ME, a capacitance value between the common electrode CE and the modulation electrode ME may be changed, thereby achieving an effect of adjusting an operating frequency band; or an effective length of the opening CE_OP of the common electrode CE may be changed, thereby achieving an effect of adjusting a resonant frequency of the opening CE_OP, but the disclosure is not limited thereto.

In the embodiment, the designs of the scan lines SL and/or the data lines DL applied to the modulation device 10a to the modulation device 10g may also be applied to the modulation device 10h to improve the signal transmission quality of the modulation device 10h. For example, by reducing the overlapping area of the scan line SL and the data line DL in the top view direction n of the substrate SB, the capacitance loading generated by the scan line SL and the data line DL may be reduced; or by making the scan line SL and/or the data line DL to include a stacked layer of the main electrode line and the auxiliary electrode line, the cross-sectional area of the scan line SL in the second direction d2 and/or the cross-sectional area of the data line DL in the first direction d1 may be increased, thereby decreasing the impedance of the scan line SL and/or the data line DL, but the disclosure is not limited thereto.

In summary, in some embodiments of the disclosure, by reducing the length of the scan line and/or the data line, increasing the cross-sectional area of the scan line and/or the data line, and/or providing a heat dissipation structure in the modulation device, the impedance of the scan line and/or the data line may be reduced. In other embodiments of the disclosure, by reducing the permittivity of the insulating layer disposed between the scan line and the data line, reducing the overlapping area of the scan line and the data line, and/or increasing the distance between the scan line and the data line in the modulation device, the capacitance loading of the scan line and/or data line may be reduced. In addition, some other embodiments of the disclosure may include a combination of the aforementioned modulation device designs, so that the impedance and capacitance loading of the scan line and/or the data line may be reduced. In this way, the modulation device provided by the embodiment of the disclosure may reduce the resistance-capacitance loading, and improve the signal transmission quality and reliability.

## Claims

1. A modulation device (10a, 10b, 10c, 10d, 10e, 10f, 10g, 10h), comprising:
a substrate (SB);
a modulation unit (AU, MEMS), disposed on the substrate (SB);
a data line (DL, DL1, DL1', DL2, DL2', DL3, DL3'), disposed on the substrate (SB) and electrically connected to the modulation unit (AU, MEMS); and
a scan line (SL, SL1, SL1', SL2, SL2'), disposed on the substrate (SB) and having an overlapping area (SL_OA) overlapping the data line (DL, DL1, DL1', DL2, DL2', DL3, DL3') and a non-overlapping area (SL_NOA) not overlapping the data line (DL, DL1, DL1', DL2, DL2', DL3, DL3'),
wherein in a first direction (d2), the scan line (SL, SL1, SL1', SL2, SL2') has a first width (SL_W1) in the overlapping area (SL_OA), the scan line (SL, SL1, SL1', SL2, SL2') has a second width (SL_W2) in the non-overlapping area (SL_NOA), and the first width (SL_W1) is smaller than the second width (SL_W2).

2. The modulation device (10a, 10b, 10c, 10d, 10c, 10f, 10g) according to claim 1, further comprising a first electrode (C1) and a second electrode (C2), wherein the first electrode (C1) and the second electrode (C2) are disposed on the substrate (SB), and the modulation unit (AU) is disposed on the first electrode (C1) and the second electrode (C2).

3. The modulation device (10a, 10b, 10c, 10d, 10e, lOf, 10g) according to claim 2, further comprising a common line (CL, CL1, CL1', CL2, CL2'), wherein the common line (CL, CL1, CL1', CL2, CL2') is electrically connected to the second electrode (C2), and the data line (DL, DL1, DL1', DL2, DL2', DL3, DL3') is electrically connected to the first electrode (C1).

4. The modulation device (10a, 10b, 10c, 10d, 10e, 10f, 10g, 10h) according to claim 1, further comprising a heat dissipation structure (TC) disposed below the substrate (SB).

5. The modulation device (10a, 10b, 10c, 10d, 10e, 10f, 10g, 10h) according to claim 1, wherein the scan line (SL, SL1, SL1', SL2, SL2') comprises a main electrode line (SLa) and an auxiliary electrode line (SLb), wherein the auxiliary electrode line (SLb) is electrically connected to the main electrode line (SLa) through a via (IL0_V1, IL1_V1, IL2 V1) penetrating through an insulating layer (IL0, IL1, IL2).

6. A modulation device (10a, 10b, 10c, 10d, 10e, 10f, 10g, 10h), comprising:
a substrate (SB);
a modulation unit (AU, MEMS), disposed on the substrate (SB);
a data line (DL, DL1, DL1', DL2, DL2', DL3, DL3'), disposed on the substrate (SB) and electrically connected to the modulation unit (AU, MEMS); and
a scan line (SL, SL1, SL1', SL2, SL2'), disposed on the substrate (SB) and partially overlapping the data line (DL, DL1, DL1 ', DL2, DL2', DL3, DL3'),
wherein the data line (DL, DL1, DL1', DL2, DL2', DL3, DL3') has an overlapping area (DL_OA) overlapping the scan line (SL, SL1, SL1', SL2, SL2') and a non-overlapping area (DL NOA) not overlapping the scan line (SL, SL1, SL1', SL2, SL2'),
wherein in a second direction (d1), the data line (DL, DL1, DL1', DL2, DL2', DL3, DL3') has a third width (DL_W1) in the overlapping area (DL_OA), the data line (DL, DL1, DL1', DL2, DL2', DL3, DL3') has a fourth width (DL_W2) in the non-overlapping area (DL_NOA), and the third width (DL_W1) is smaller than the fourth width (DL_W2).

7. The modulation device (10a, 10b, 10c, 10d, 10e, 10f, 10g) according to claim 6, further comprising a first electrode (C1) and a second electrode (C2), wherein the first electrode (C1) and the second electrode (C2) are disposed on the substrate (SB), and the modulation unit (AU) is disposed on the first electrode (C1) and the second electrode (C2).

8. The modulation device (10a, 10b, 10c, 10d, 10e, 10f, 10g) according to claim 7, further comprising a common line (CL, CL1, CL1', CL2, CL2'), wherein the common line (CL, CL1, CL1', CL2, CL2') is electrically connected to the second electrode (C2), and the data line (DL, DL1, DL1', DL2, DL2', DL3, DL3') is electrically connected to the first electrode (C1).

9. The modulation device (10a, 10b, 10c, 10d, 10e, 10f, 10g, 10h) according to claim 6, further comprising a heat dissipation structure (TC) disposed below the substrate (SB).

10. The modulation device (10a, 10b, 10c, 10d, 10e, 10f, 10g, 10h) according to claim 6, wherein the data line (DL, DL1, DL1', DL2, DL2', DL3, DL3') comprises a main electrode line (DLa) and an auxiliary electrode line (DLb), wherein the auxiliary electrode line (DLb) is electrically connected to the main electrode line (DLa) through a via (IL0_V2) penetrating through an insulating layer (IL0).

11. A modulation device (10b, 10c), comprising:
a substrate (SB);
a plurality of modulation units (AU), disposed on the substrate (SB);
a data line (DL), disposed on the substrate (SB) and electrically connected to at least one of the modulation units (AU); and
a scan line (SL), disposed on the substrate (SB) and disposed in parallel with the data line (DL).

12. The modulation device (10b) according to claim 11, further comprising a driving circuit (DC), wherein the driving circuit (DC) is disposed on the substrate (SB), and the driving circuit (DC) is disposed in a peripheral area of the substrate (SB).

13. The modulation device (10c) according to claim 11, further comprising a driving circuit (DC), wherein the driving circuit (DC) is disposed on the substrate (SB), and the driving circuit (DC) is disposed in a middle area of the substrate (SB).

14. The modulation device (10b, 10c) according to claim 11, further comprising a plurality of chips, wherein the chips are disposed below the substrate (SB), and the chips drive the modulation units (AU) in a partition manner.

15. The modulation device (10b, 10c) according to claim 14, wherein the chips are formed below the substrate (SB) through a panel level package process.
